# EUROPEAN PATENT APPLICATION

(11) **EP 4 745 964 A1**
(43) Date of publication of application: **20.05.2026**
(21) Application number: 24839267.2
(22) Date of filing: 17.04.2024
(51) Int. Cl.: G11B 5/37, G11B 5/09, G11B 5/31, G11B 5/65, H01F 10/16, H10B 61/00, H10N 52/00

(54) **REPRODUCING HEAD USING ANOMALOUS HALL EFFECT, MAGNETIC DISK DEVICE, AND MAGNETIC STORAGE DEVICE**

(30) Priority: 13.07.2023 JP 2023115437
(71) Applicant: National Institute for Materials Science, Tsukuba-shi, Ibaraki 305-0047 (JP)
(72) Inventor: KULKARNI, Prabhanjan Dilip, Tsukuba-shi, Ibaraki 305-0047 (JP); IWASAKI, Hitoshi, Tsukuba-shi, Ibaraki 305-0047 (JP); NAKATANI, Tomoya, Tsukuba-shi, Ibaraki 305-0047 (JP)
(74) Representative: V.O.
(86) International application number: PCT/JP2024/015288
(87) International publication number: WO 2025/013369

(57) **Abstract**

A recording head using the anomalous Hall effect includes a ferromagnetic body 10 configured to exhibit the anomalous Hall effect, first and second current terminals (I+, I-) configured to supply a current to the ferromagnetic body 10, first and second voltage terminals (V+, V-) configured to detect a voltage generated in the ferromagnetic body 10, and a resistance adjustment layer provided between each of the first and second current terminals and the ferromagnetic body or between each of the first and second voltage terminals and the ferromagnetic body; the resistance adjustment layer includes a high-resistance region and a low-resistance region; and the low-resistance region electrically connects each of the first and second current terminals and the ferromagnetic body or electrically connects each of the first and second voltage terminals and the ferromagnetic body.

## Description

### TECHNICAL FIELD

The present invention relates to a recording head using the anomalous Hall effect, a magnetic disk device, and a magnetic storage device. Priority is claimed on Japanese Patent Application No. 2023-115437, filed July 13, 2023, the content of which is incorporated herein by reference.

### BACKGROUND ART

With an increase in the areal recording density of a magnetic recording device (hard disk), improvement in the characteristics of a recording head is required. The recording head is a component of the hard disk and is a magnetic sensor that records magnetic information recorded on a magnetic recording medium. In a case where the areal recording density exceeds 2 terabits/square inch, the dimension of the recording head will be 20 nm or less. In a current tunnel magnetoresistive element, it is difficult to obtain a sufficient signal-to-noise ratio with such a small recording head.

For example, Patent Documents 1 and 2 disclose a recording head using the anomalous Hall effect of a ferromagnetic body. Further, for example, Patent Document 3 discloses a current-perpendicular-to-plane giant magnetoresistive element, which can be suitably used for a recording head, and a film structure of a spin valve.

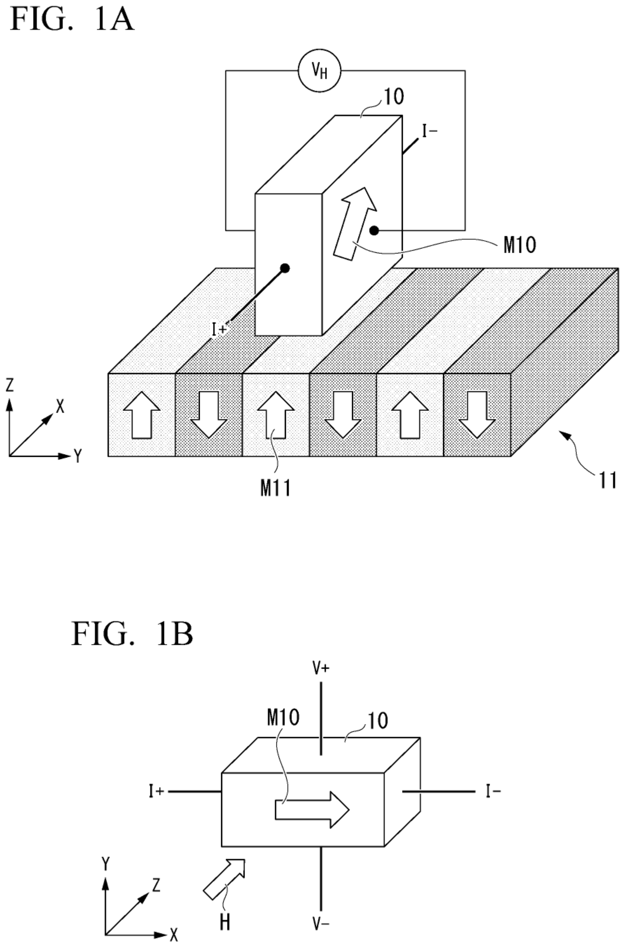

FIG. 1A is a conceptual diagram of a recording head using the anomalous Hall effect in the related art. FIG. 1A shows a positional relationship between the recording head and a magnetic recording medium 11. A ferromagnetic body 10 used in the recording head has a rectangular parallelepiped shape, and two pairs of terminals orthogonal to each other are mounted on the ferromagnetic body 10. Bias currents I+ and I- are allowed to flow from one pair of terminals, and voltages V+ and V- are measured at the other pair of terminals. A direction of magnetization M10 of the ferromagnetic body 10 is changed depending on a magnetic field caused by magnetization M II stored in the magnetic recording medium 11. In a case where the magnetization M10 is rotated in a direction orthogonal to these two pairs of terminals, a voltage caused by the anomalous Hall effect is generated between the voltage terminals and the recorded magnetic information is recorded. A surface of the recording head facing the magnetic recording medium is called an air bearing surface (ABS) and is protected by diamond-like carbon (DLC).

The magnetic recording medium 11 has a magnetic storage pattern disposed in stripes in an in-plane direction and has a magnetic recording track that performs magnetic storage by perpendicular magnetization. In FIG. 1A, a y direction is a down-track direction, an x direction is a cross-track direction, and a z direction is a perpendicular magnetization direction.

FIG. 1B is a perspective view of a configuration showing details of a first type of recording head using the anomalous Hall effect. FIG. 1B shows bias current terminals I+ and I- and voltage detection terminals V+ and V-. One of the bias current terminals I+ and I- is a first current terminal, and the other thereof is a second current terminal. One of the voltage detection terminals V+ and V- is a first voltage terminal, and the other thereof is a second voltage terminal. A y direction in FIG. 1B is a voltage direction of a voltage generated between the pair of voltage detection terminals V+ and V-, an x direction is a current direction of a current flowing between the pair of bias current terminals I+ and I-, and a z direction is a perpendicular magnetization direction of the magnetic recording medium 11. A leakage magnetic field H from the magnetic recording medium 11 is applied to the ferromagnetic body 10. The z direction is orthogonal to the air bearing surface and is orthogonal to a plane defined by the x direction and the y direction.

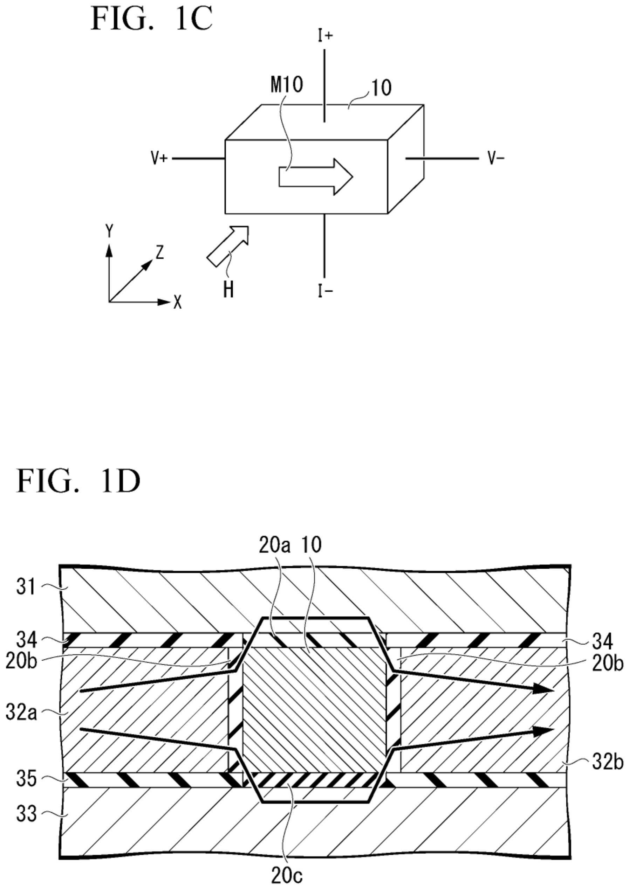

In the case of the first type, the voltage detection terminals V+ and V- are upper and lower shields 31 and 33 in FIG. 1D, and the bias current terminals I+ and I- are side shields 32a and 32b in FIG. 1D.

FIG. 1C is a perspective view of a configuration showing details of a second type of recording head using the anomalous Hall effect. The arrangement of the bias current terminals I+ and I- and the voltage detection terminals V+ and V- is different from that shown in FIG. 1B. A y direction in FIG. 1C is a current direction of a current flowing between the pair of bias current terminals I+ and I-, an x direction is a voltage direction of a voltage generated between the pair of voltage detection terminals V+ and V-, and a z direction is a perpendicular magnetization direction of the magnetic recording medium. The z direction is orthogonal to the air bearing surface and is orthogonal to a plane defined by the x direction and the y direction.

In the case of the second type, the bias current terminals I+ and I- are upper and lower shields 31 and 33 in FIG. 1D, and the voltage detection terminals V+ and V- are side shields 32a and 32b in FIG. 1D.

### Citation List

### Patent Documents

Patent Document 1: Japanese Unexamined Patent Application, First Publication No. 2003-069107
Patent Document 2: United States Patent No. 7576948
Patent Document 3: Japanese Patent No. 7066222

### Non-Patent Document

Non-Patent Document 1: Nakatani et al., "Study of a Read Sensor for HDDs Using the Anomalous Hall Effect," 46th Annual Conference of the Magnetics Society of Japan, Presentation No. 08aA-9 (2022)

### SUMMARY OF INVENTION

### Technical Problem

In the recording head using the anomalous Hall effect, the shape of the terminal is not actually linear. As shown in FIG. 1D, metal thin films formed of soft magnetic bodies and surrounding the ferromagnetic body 10 correspond to the terminals and are called the upper shield 31, the lower shield 33, and the side shields 32a and 32b. Further, details of the structure of the recording head will be described. An insulator layer 34 is formed between the upper shield 31 and the side shields 32a and 32b, and an insulator layer 35 is formed between the lower shield 33 and the side shields 32a and 32b. Furthermore, a non-magnetic layer 20a is provided between the ferromagnetic body 10 and the upper shield 31. A non-magnetic layer 20c is provided between the ferromagnetic body 10 and the lower shield 33. A non-magnetic layer 20b is provided between the ferromagnetic body 10 and each of the side shields 32a and 32b. The side shields 32a and 32b are positioned on the left and right sides of the ferromagnetic body 10 and the non-magnetic layers 20b with the ferromagnetic body 10 and the non-magnetic layers 20b interposed therebetween. These shields 31, 32a, 32b, and 33 serve to block a leakage magnetic field generated from the magnetic recording medium to improve the resolution of the recording head (see Non-Patent Document 1).

As a result of intensive studies performed by the present inventors, it has been found that there are the following problems in a case where the recording head is operated in the above-described structure.

A first problem is that a bias current is shunted (bypassed) to the shields functioning as the voltage detection terminals (V+, V-). The shunting of the bias current causes a decrease in output voltage (see Patent Document 2).

A second problem is that an anomalous Hall voltage leaks to the shields functioning as the bias current terminals (I+, I-). This leakage causes a decrease in output voltage.

Due to these problems, there is a problem that sufficient output required for the recording head cannot be obtained in a case where the output voltage of the recording head decreases.

The present disclosure is to solve the above problems in the related art. An object of the present disclosure is to provide a recording head using the anomalous Hall effect that can suppress a decrease in output voltage caused in a case where a bias current is shunted to voltage detection terminals or an anomalous Hall voltage leaks to bias current terminals.

### Solution to Problem

As means for solving the above-described problems, a structure for suppressing the shunting of a bias voltage to shields and a structure for suppressing the leakage of an anomalous Hall voltage to shields are provided inside the shields or between the ferromagnetic body and the shields. For this purpose, the following means are used in the present disclosure.

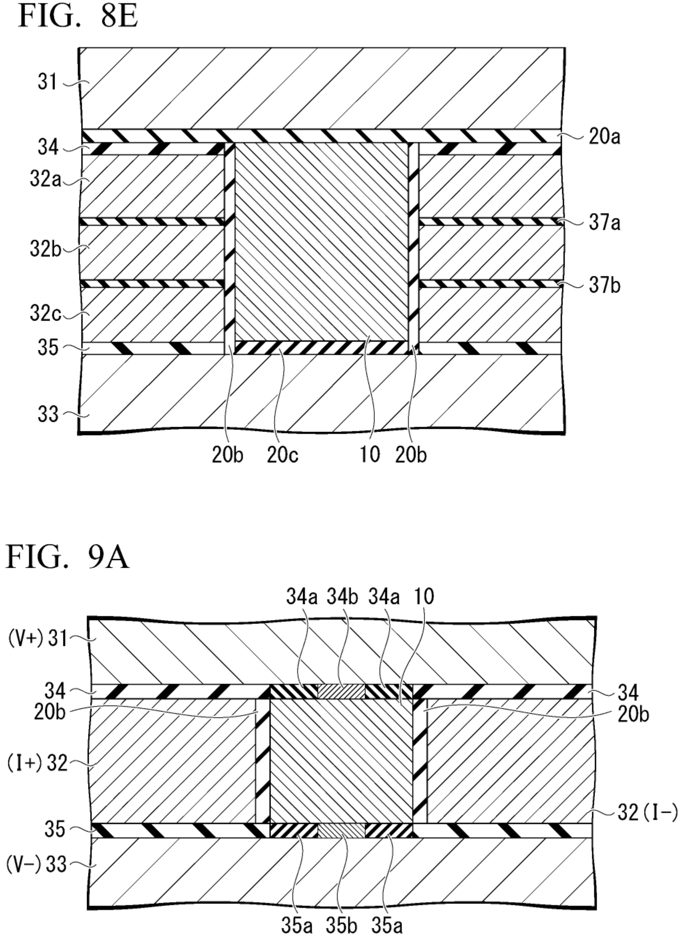

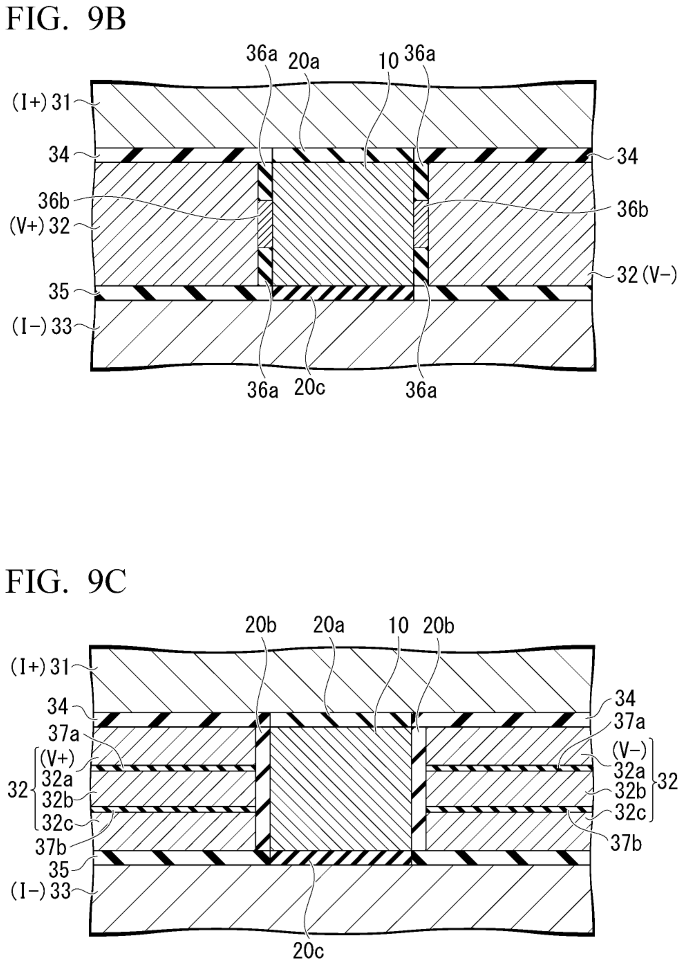

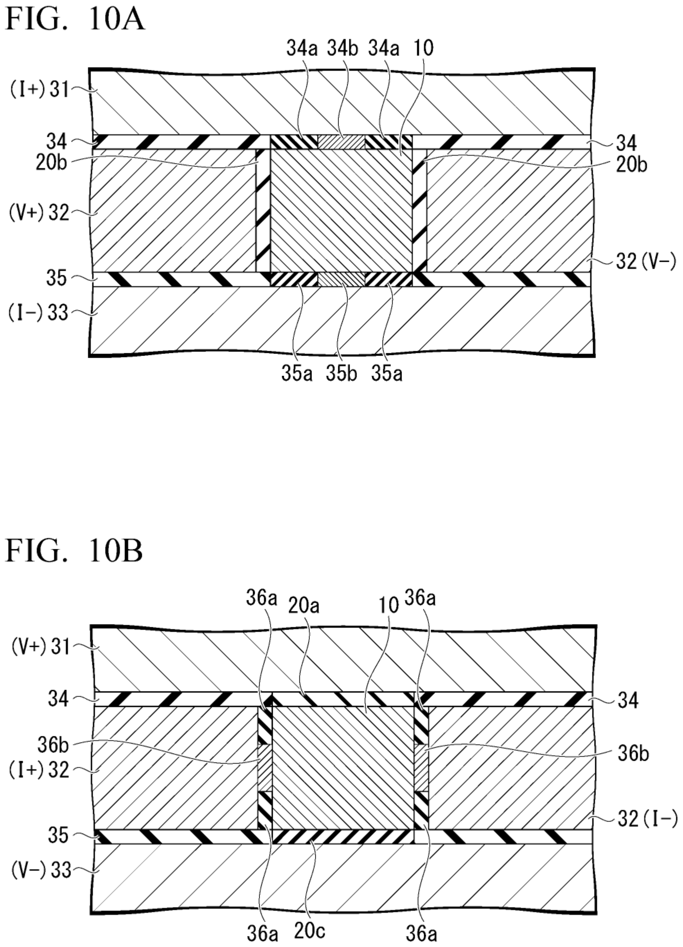

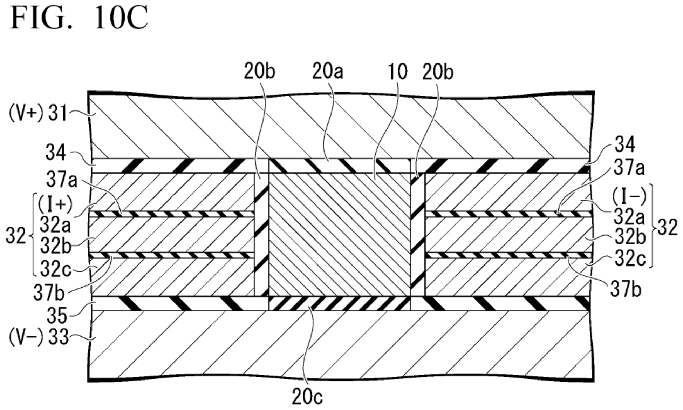

[1] A recording head using the anomalous Hall effect according to a first aspect is shown in, for example, FIGS. 9A, 9B, 10A, and 10B. The recording head according to the first aspect includes a ferromagnetic body 10 configured to exhibit the anomalous Hall effect, first and second current terminals (I+, I-) configured to supply a current to the ferromagnetic body 10, first and second voltage terminals (V+, V-) configured to detect a voltage generated in the ferromagnetic body 10, and a resistance adjustment layer (34a, 34b, 35a, 35b, 36a, 36b) provided between each of the first and second current terminals and the ferromagnetic body or between each of the first and second voltage terminals and the ferromagnetic body. In a case where a current direction of a current flowing between the first and second current terminals is defined as a first direction and a voltage direction of a voltage generated between the first and second voltage terminals is defined as a second direction, the recording head according to the first aspect detects a magnetic field applied in a third direction orthogonal to an air bearing surface. In the recording head according to the first aspect, the resistance adjustment layer includes a high-resistance region and a low-resistance region. The low-resistance region electrically connects each of the first and second current terminals and the ferromagnetic body or electrically connects each of the first and second voltage terminals and the ferromagnetic body.
[2] In the recording head using the anomalous Hall effect according to the aspect, the low-resistance region may be present at a center of the resistance adjustment layer.
[3] In the recording head using the anomalous Hall effect according to the aspect, the ferromagnetic body exhibiting the anomalous Hall effect may contain at least two elements selected from the group consisting of cobalt, nickel, iron, holmium, platinum, osmium, bismuth, boron, dysprosium, gadolinium, and terbium.
[4] In the recording head using the anomalous Hall effect according to the aspect, the ratio of the resistivity of the high-resistance region to a resistivity of the low-resistance region may be 100 or more.
[5] In the recording head using the anomalous Hall effect according to the aspect, the resistivity of the high-resistance region may be 10⁴ µΩ·cm or more and 10⁸ µΩ·cm or less.
[6] In the recording head using the anomalous Hall effect according to the aspect, the resistivity of the low-resistance region may be 10² µΩ·cm or more and 10⁴ µΩ·cm or less.
[7] In the recording head using the anomalous Hall effect according to the aspect, the high-resistance region may contain an oxide or a nitride selected from the group consisting of SiOₓ, AlOₓ, MgO, MgTiO, MgAlO, TaOₓ, HfOₓ, and SiN.
[8] In the recording head using the anomalous Hall effect according to the aspect, the low-resistance region may contain a metal selected from the group consisting of Ru, Ag, Au, Cu, and Ta or an alloy of these metal elements.
[9] In the recording head using the anomalous Hall effect according to the aspect, a material of the ferromagnetic body may be an alloy exhibiting an anomalous Hall resistivity of 1 µΩ·cm or more.
[10] In the recording head using the anomalous Hall effect according to the aspect, the material of the ferromagnetic body may include an alloy selected from the group consisting of Co₂MnAl, Co₂MnGa, and FeSn.
[11] In the recording head using the anomalous Hall effect according to the aspect, the first current terminal, the second current terminal, the first voltage terminal, and the second voltage terminal may contain a high-permeability ferromagnetic material.
[12] In the recording head using the anomalous Hall effect according to the aspect, the first current terminal, the second current terminal, the first voltage terminal, and the second voltage terminal may contain NiFe.
[13] In the recording head using the anomalous Hall effect according to the aspect, the third direction may be orthogonal to the first direction and the second direction.
[14] A recording head using the anomalous Hall effect according to a second aspect is shown in, for example, FIGS. 9C and 10C. The recording head using the anomalous Hall effect according to the second aspect includes a ferromagnetic body 10 configured to exhibit the anomalous Hall effect; first and second current terminals (I+, I-) configured to supply a current to the ferromagnetic body 10; and first and second voltage terminals (V+, V-) configured to detect a voltage generated in the ferromagnetic body 10. In a case where a current direction of a current flowing between the first and second current terminals is defined as a first direction and a voltage direction of a voltage generated between the first and second voltage terminals is defined as a second direction, the recording head using the anomalous Hall effect according to the second aspect detects a magnetic field applied in a third direction orthogonal to an air bearing surface. Each of the first current terminal and the second current terminal have a multilayer structure. Soft magnetic layers (32a, 32b, 32c) and intermediate layers (37a, 37b) extending along the second direction are alternately laminated in the multilayer structure, and the intermediate layer has a higher resistance than the soft magnetic layer.
[15] In the recording head using the anomalous Hall effect according to the aspect, the ratio of the resistivity of the intermediate layer to the resistivity of the soft magnetic layer may be 100 or more.
[16] In the recording head using the anomalous Hall effect according to the aspect, the soft magnetic layer may contain a high-permeability ferromagnetic material.
[17] In the recording head using the anomalous Hall effect according to the aspect, the soft magnetic layer may contain NiFe.
[18] In the recording head using the anomalous Hall effect according to the aspect, the intermediate layer may contain an oxide or a nitride selected from the group consisting of SiOₓ, AlOₓ, MgO, MgTiO, MgAlO, TaOₓ, HfOₓ, and SiN.
[19] In the recording head using the anomalous Hall effect according to the aspect, the thickness of the soft magnetic layer may be 2 times or more the thickness of the intermediate layer.
[20] In the recording head using the anomalous Hall effect according to the aspect, the first and second voltage terminals may contain a high-permeability ferromagnetic material.
[21] In the recording head using the anomalous Hall effect according to the aspect, the first and second voltage terminals may contain NiFe.
[22] In the recording head using the anomalous Hall effect according to the aspect, the third direction may be orthogonal to the first direction and the second direction.
[23] A magnetic disk device according to a third aspect includes a magnetic head, a slider disposed to face a recording medium to be rotationally driven, and a positioning device configured to support the slider and to position the slider with respect to the recording medium. The magnetic head has a medium-facing surface (air bearing surface) facing the recording medium. The magnetic head includes the recording head using the anomalous Hall effect according to the aspect in the vicinity of the medium-facing surface, to detect a signal magnetic field from the recording medium.
[24] A magnetic storage device according to a fourth aspect is shown in, for example, FIG. 1A. The magnetic storage device according to the fourth aspect includes a magnetic recording medium having a magnetic storage pattern disposed in stripes in an in-plane direction and configured to perform magnetic storage by perpendicular magnetization, and a recording head facing the magnetic recording medium and configured to read the magnetic storage pattern. The recording head is the recording head using the anomalous Hall effect according to the aspect.

### Advantageous Effects of Invention

Since the recording head using the anomalous Hall effect according to the present disclosure includes a structure for suppressing the shunting of a bias voltage to shields and a structure for suppressing the leakage of an anomalous Hall voltage to shields, inside the shields or between the ferromagnetic body and the shields, a sufficient output as a recording head can be obtained.

For example, in a case where a recording head having the structure of the first embodiment shown in FIG. 9A, the second embodiment shown in FIG. 9B, or the third embodiment shown in FIG. 9C is used, it is possible to prevent a bias current flowing through the ferromagnetic body from being shunted to the shields functioning as the bias current terminals (I+, I-).

Further, in a case where a recording head having the structure of the first embodiment shown in FIG. 10A, the second embodiment shown in FIG. 10B, or the third embodiment shown in FIG. 10C is used, it is possible to suppress the leakage of an output voltage, which is generated in the ferromagnetic body due to the anomalous Hall effect, with the shields functioning as the bias current terminals (I+, I-).

### BRIEF DESCRIPTION OF DRAWINGS

FIG. 1A is a conceptual diagram of a recording head using the anomalous Hall effect in the related art, and shows a positional relationship between a magnetic recording medium and the recording head.
FIG. 1B is a perspective view of a configuration showing details of a first type of recording head.
FIG. 1C is a perspective view of a configuration showing details of a second type of recording head.
FIG. 1D is a view of the recording head as viewed from an air bearing surface side, and shows a specific example of a shape of a terminal.
FIG. 2A is a schematic diagram of a recording head using the anomalous Hall effect according to a first embodiment.
FIG. 2B is a schematic diagram of a recording head using the anomalous Hall effect according to a second embodiment.
FIG. 2C is a schematic diagram of a recording head using the anomalous Hall effect according to a third embodiment.
FIG. 3A is a schematic diagram of the recording head using the anomalous Hall effect according to the first embodiment.
FIG. 3B is a schematic diagram of the recording head using the anomalous Hall effect and having a structure in the related art.
FIG. 3C shows a relationship between a diameter of a low-resistance pinhole layer of the recording head according to the first embodiment and a normalized output voltage.
FIG. 3D shows a relationship between the resistivity of a high-resistance layer of the recording head according to the first embodiment and a normalized output voltage.
FIG. 4A is a schematic diagram of a first modification example of the recording head using the anomalous Hall effect according to the first embodiment.
FIG. 4B shows a relationship between the position of a low-resistance pinhole layer of the recording head according to the first modification example and a normalized output voltage.
FIG. 5A is a diagram showing a process for manufacturing the recording head using the anomalous Hall effect according to the first embodiment.
FIG. 5B is a diagram showing a process for manufacturing the recording head using the anomalous Hall effect according to the first embodiment.
FIG. 5C is a diagram showing a process for manufacturing the recording head using the anomalous Hall effect according to the first embodiment.
FIG. 5D is a diagram showing a process for manufacturing the recording head using the anomalous Hall effect according to the first embodiment.
FIG. 5E is a diagram showing a process for manufacturing the recording head using the anomalous Hall effect according to the first embodiment.
FIG. 5F is a diagram showing a process for manufacturing the recording head using the anomalous Hall effect according to the first embodiment.
FIG. 5G is a diagram showing a process for manufacturing the recording head using the anomalous Hall effect according to the first embodiment.
FIG. 5H is a diagram showing a process for manufacturing the recording head using the anomalous Hall effect according to the first embodiment.
FIG. 5I is a diagram showing a process for manufacturing the recording head using the anomalous Hall effect according to the first embodiment.
FIG. 5J is a diagram showing a process for manufacturing the recording head using the anomalous Hall effect according to the first embodiment.
FIG. 5K is a diagram showing a process for manufacturing the recording head using the anomalous Hall effect according to the first embodiment.
FIG. 5L is a diagram showing a process for manufacturing the recording head using the anomalous Hall effect according to the first embodiment.
FIG. 5M is a diagram showing a process for manufacturing the recording head using the anomalous Hall effect according to the first embodiment.
FIG. 6A is a schematic diagram of the recording head using the anomalous Hall effect according to the second embodiment.
FIG. 6B shows a relationship between a diameter of a low-resistance pinhole layer of the recording head according to the second embodiment and a normalized output voltage.
FIG. 6C shows a relationship between a resistivity of a high-resistance layer of the recording head according to the second embodiment and a normalized output voltage.
FIG. 7A is a schematic diagram of the recording head using the anomalous Hall effect according to the third embodiment.
FIG. 7B shows a relationship between the resistivity of a high-resistance layer of the recording head according to the third embodiment and the normalized output voltage.
FIG. 8A is a diagram showing a process for manufacturing the recording head using the anomalous Hall effect according to the third embodiment.
FIG. 8B is a diagram showing a process for manufacturing the recording head using the anomalous Hall effect according to the third embodiment.
FIG. 8C is a diagram showing a process for manufacturing the recording head using the anomalous Hall effect according to the third embodiment.
FIG. 8D is a diagram showing a process for manufacturing the recording head using the anomalous Hall effect according to the third embodiment.
FIG. 8E is a diagram showing a process for manufacturing the recording head using the anomalous Hall effect according to the third embodiment.
FIG. 9A is a diagram showing a structure for preventing a bias current flowing through a ferromagnetic body from being shunted to a shield serving as bias current terminals (I+, I-) in the recording head using the anomalous Hall effect according to the first embodiment.
FIG. 9B is a diagram showing a structure for preventing a bias current flowing through the ferromagnetic body from being shunted to a shield serving as bias current terminals (I+, I-) in the recording head using the anomalous Hall effect according to the second embodiment.
FIG. 9C is a diagram showing a structure for preventing a bias current flowing through the ferromagnetic body from being shunted to a shield serving as bias current terminals (I+, I-) in the recording head using the anomalous Hall effect according to the third embodiment.
FIG. 10A is a diagram showing a structure for suppressing a phenomenon in which an output voltage caused by the anomalous Hall effect occurring in the ferromagnetic body leaks due to the shield serving as the bias current terminals (I+, I-) in the recording head using the anomalous Hall effect according to the first embodiment.
FIG. 10B is a diagram showing a structure for suppressing a phenomenon in which an output voltage caused by the anomalous Hall effect occurring in the ferromagnetic body leaks due to the shield serving as the bias current terminals (I+, I-) in the recording head using the anomalous Hall effect according to the first embodiment.
FIG. 10C is a diagram showing a structure for suppressing a phenomenon in which an output voltage caused by the anomalous Hall effect occurring in the ferromagnetic body leaks due to the shield serving as the bias current terminals (I+, I-) in the recording head using the anomalous Hall effect according to the first embodiment.

### DESCRIPTION OF EMBODIMENTS

First, technical terms used in the present specification will be described.

The anomalous Hall effect refers to the Hall effect unique to a magnetic body. The anomalous Hall effect is a phenomenon in which, in a case where a current is applied to a magnetic body, the current is deflected in a direction orthogonal to both the applied current and the magnetization of the magnetic body. The anomalous Hall effect is known to originate from an intrinsic mechanism caused by the electronic structure of a material and an extrinsic mechanism originating from impurity scattering and the like.

Next, a specific example of a recording head according to the present embodiment will be described with reference to the following drawings.

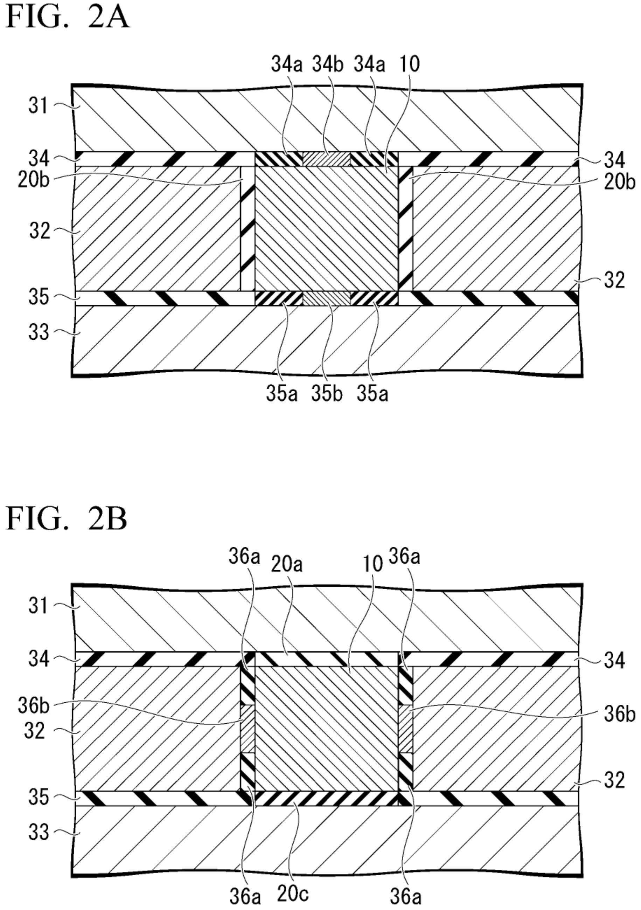

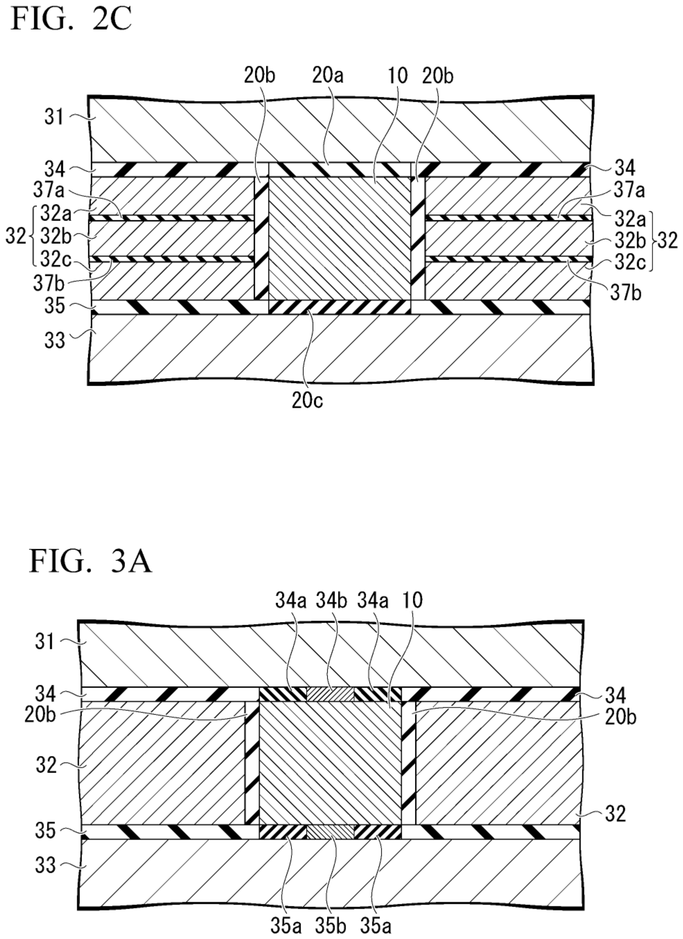

FIG. 2A is a schematic diagram of a recording head using the anomalous Hall effect according to a first embodiment. FIG. 2B is a schematic diagram of a recording head using the anomalous Hall effect according to a second embodiment. FIG. 2C is a schematic diagram of a recording head using the anomalous Hall effect according to a third embodiment.

### <First embodiment>

The recording head shown in the first embodiment includes a laminate of metal thin films that are formed of soft magnetic bodies and surround a ferromagnetic body 10 as shown in FIG. 2A. Each of the soft magnetic bodies is called an upper shield 31, a lower shield 33, and side shields 32. Details of the structure of the recording head will be described. A high-resistance layer (or an insulator layer) 34 is provided between the upper shield 31 and the side shields 32. A high-resistance layer (or an insulator layer) 35 is provided between the lower shield 33 and the side shields 32. A resistance adjustment layer is provided between the ferromagnetic body 10 and the upper shield 31. The resistance adjustment layer includes a high-resistance layer 34a corresponding to a high-resistance region and a low-resistance pinhole layer 34b corresponding to a low-resistance region. A resistance adjustment layer is provided between the ferromagnetic body 10 and the lower shield 33. The resistance adjustment layer includes a high-resistance layer 35a corresponding to a high-resistance region and a low-resistance pinhole layer 35b corresponding to a low-resistance region. A non-magnetic layer 20b is provided between the ferromagnetic body 10 and each of the side shields 32. The side shields 32 are positioned on the left and right sides of the ferromagnetic body 10 and the non-magnetic layers 20b with the ferromagnetic body 10 and the non-magnetic layers 20b interposed therebetween.

The recording head according to the first embodiment includes the low-resistance pinhole layers 34b and 35b surrounded by the high-resistance layers 34a and 35a between the upper and lower shields 31 and 33 and the ferromagnetic body 10. A finite element method simulation was performed to evaluate the effect of this structure.

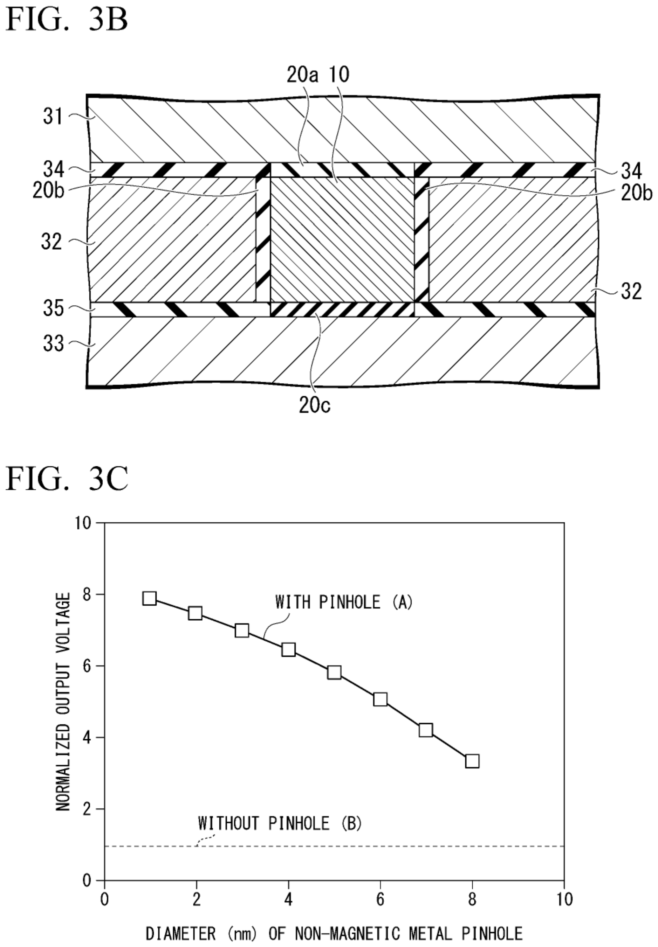

FIG. 3A is a configuration diagram of the recording head using the anomalous Hall effect according to the first embodiment used in the simulation. FIG. 3B is a configuration diagram of a recording head including no low-resistance pinhole layer used in the simulation as a comparative example.

As shown in FIGS. 1B and 1C, a ferromagnetic body 10 has a substantially rectangular parallelepiped shape and is represented by three-dimensional coordinates of an x direction, a y direction, and a z direction. The dimensions of the ferromagnetic body 10 are 9 nm in the x direction, 9 nm in the z direction, and 13 nm in the y direction. The resistivity of the ferromagnetic body 10 is 220 µΩ·cm. The material of the ferromagnetic body 10 is, for example, Co₂MnAl, Co₂MnGa Heusler alloy, FeSn, and the like. The material of the ferromagnetic body 10 preferably includes an alloy exhibiting an anomalous Hall resistivity of 1 µΩ·cm or more, and preferably includes, for example, alloys of elements selected from the group consisting of cobalt, nickel, iron, holmium, platinum, osmium, bismuth, boron, dysprosium, gadolinium, and terbium.

In a case of conforming to the structure of a first type of recording head using the anomalous Hall effect shown in FIG. 1B, the x direction is a current direction (first direction) of a current flowing between a pair of bias current terminals I+ and I- and the y direction is a voltage direction (second direction) of a voltage generated between a pair of voltage detection terminals V+ and V-. The z direction corresponds to a third direction. Further, in a case of conforming to the structure of a second type of recording head using the anomalous Hall effect shown in FIG. 1C, the y direction is a current direction (first direction) of a current flowing between a pair of bias current terminals I+ and I- and the x direction is a voltage direction (second direction) of a voltage generated between a pair of voltage detection terminals V+ and V-. Even in this case, the z direction corresponds to a third direction.

The resistivity of each of the upper shield 31, the lower shield 33, and the side shields 32 is, for example, 20 µΩ·cm, and these shields may contain, for example, NiFe.

The low-resistance pinhole layers 34b and 35b are provided above and below the ferromagnetic body 10, and the shapes thereof are circular in a zx plane. The high-resistance layers 34a and 35a are present around the low-resistance pinhole layers 34b and 35b.

The resistivity of each of the pinhole layers 34b and 35b is, for example, 25 µΩ·cm, and these pinhole layers may contain, for example, Ru. The low-resistance pinhole layers 34b and 35b correspond to the low-resistance regions of the resistance adjustment layers, and the high-resistance layers 34a and 35a correspond to the high-resistance regions of the resistance adjustment layers.

The same material may be used for the high-resistance layers (or insulator layers) 34 and 35 and the high-resistance layers 34a and 35a corresponding to the high-resistance regions of the resistance adjustment layers. For example, an oxide or a nitride selected from the group consisting of SiOₓ, AlOₓ, MgO, MgTiO, MgAl, TaOₓ, HfOₓ, and SiN can be used for the high-resistance layers 34a and 35a.

The ratio of the resistivity of the high-resistance region of the resistance adjustment layer to the resistivity of the low-resistance region of the resistance adjustment layer is preferably 100 or more and 10⁶ or less and more preferably 100 or more and 10⁴ or less. The resistivity of the high-resistance region of the resistance adjustment layer may be 10⁴ µΩ·cm or more and 10⁸ µΩ·cm or less. The resistivity of the low-resistance region of the resistance adjustment layer may be 10² µΩ·cm or more and 10⁴ µΩ·cm or less. Further, the material of the low-resistance region of the resistance adjustment layer is not limited to Ru, and may be Ag, Au, Cu, or Ta, or may be an alloy thereof.

FIG. 3C shows the dependence of an output voltage of the recording head according to the first embodiment on the diameters of the low-resistance pinhole layers 34b and 35b. The output voltage is normalized by an output voltage obtained in a case where the low-resistance pinhole layers are not provided (the comparative example shown in FIG. 3B). The output voltage of the recording head including the low-resistance pinhole layers 34b and 35b is significantly increased as compared with the output voltage of the recording head of the comparative example not including the low-resistance pinhole layers 34b and 35b, and the effect thereof is greater as the diameters of the low-resistance pinhole layers 34b and 35b are smaller.

The same effect can be obtained even in a case where the low-resistance pinhole layers 34b and 35b have a slit shape having the same dimension as the dimension of the ferromagnetic body 10 in the y direction instead of a circular shape.

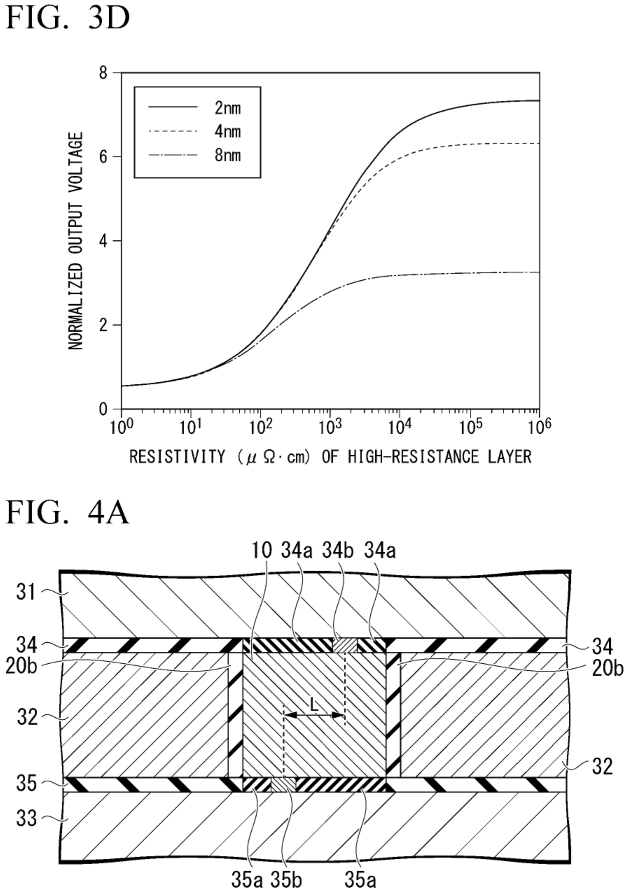

FIG. 3D shows a relationship between the resistivity of the high-resistance layers 34a and 35a and the output voltage in cases where the diameter of the low-resistance pinhole layer is each 2 nm, 4 nm, and 8 nm. In order to obtain a high output voltage, the resistivity of the high-resistance layers 34a and 35a may be generally 10⁴ µΩ·cm or more and 10⁸ µΩ·cm or less.

It is most desirable that the positions of the low-resistance pinhole layers 34b and 35b are at the center of the ferromagnetic body 10. Results showing this are as follows.

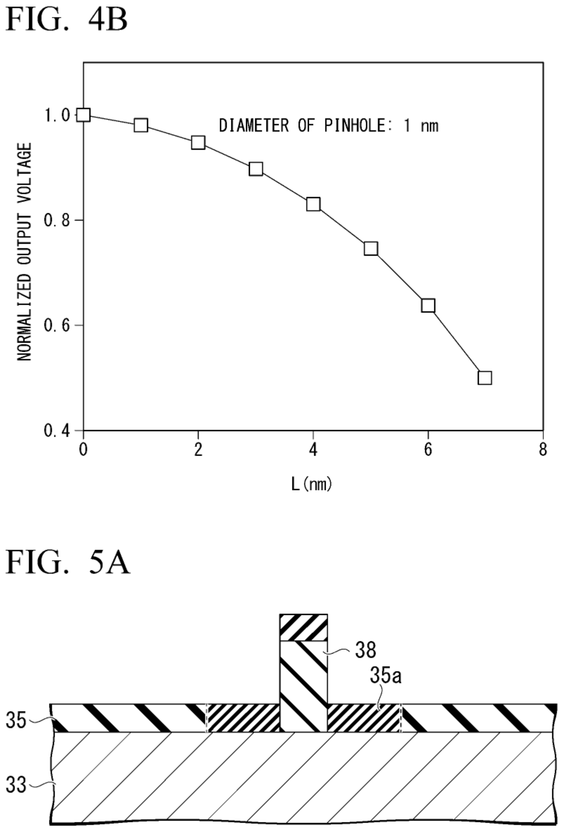

As shown in FIG. 4A, FIG. 4B shows a change in output voltage in a case where each of the positions of the low-resistance pinhole layers 34b and 35b provided above and below is shifted from the center of the ferromagnetic body 10 by L/2. As the misregistration amount L increases, the output voltage decreases. The reason for this is that the leakage of the output voltage caused by the side shields 32 is larger as the misregistration amount L is larger.

FIGS. 5A to 5M are diagrams showing processes for manufacturing the recording head using the anomalous Hall effect according to the first embodiment.

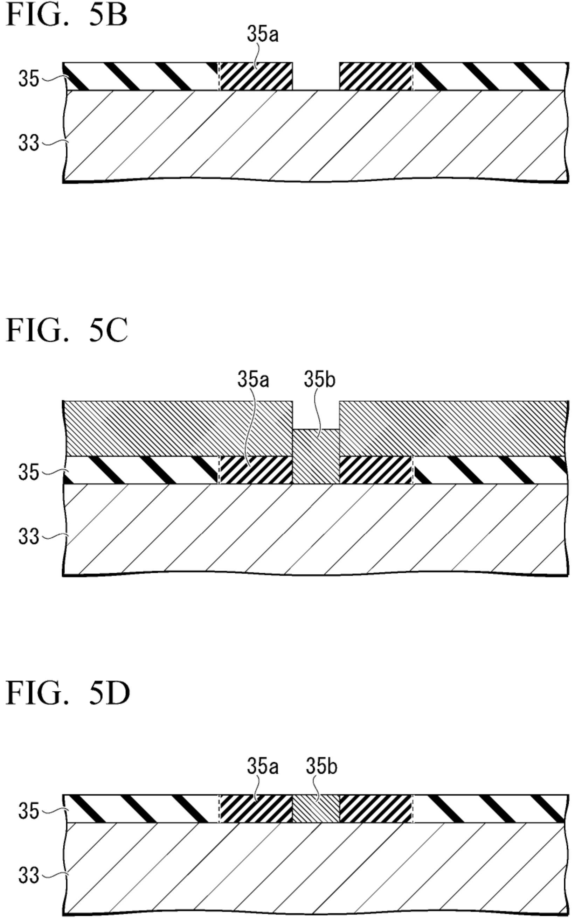

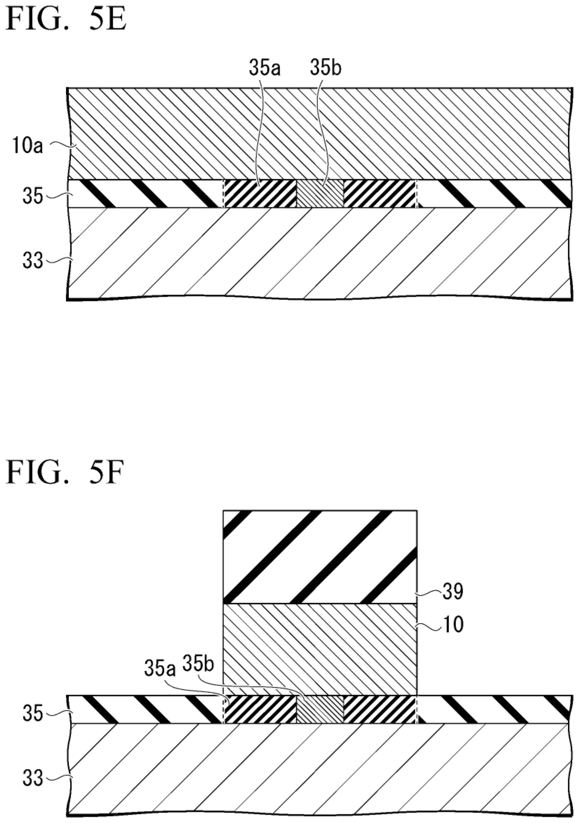

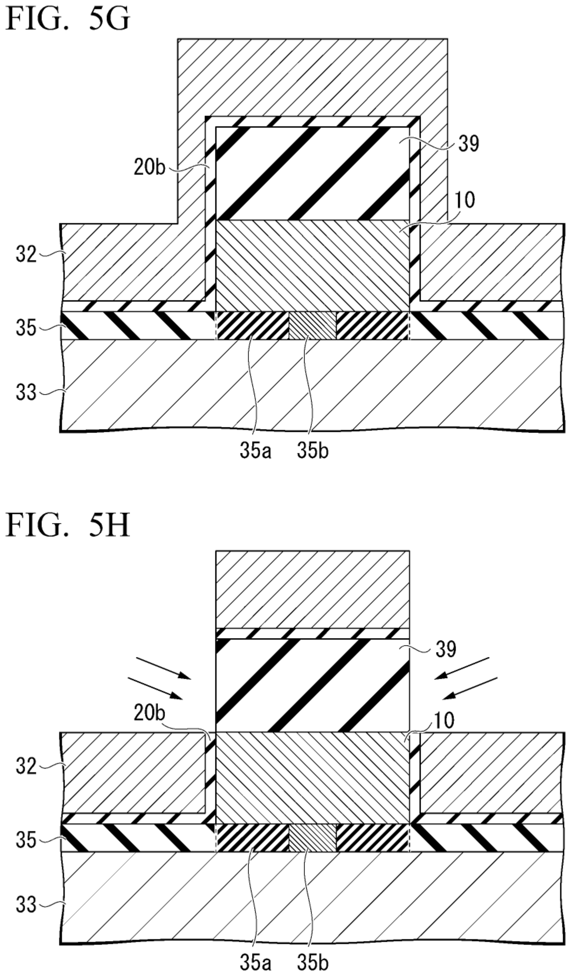

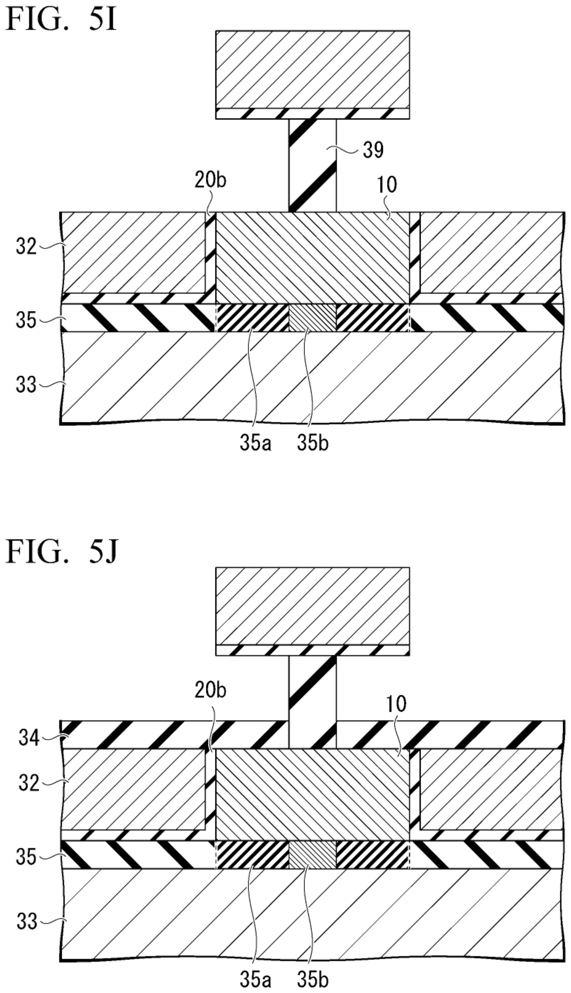

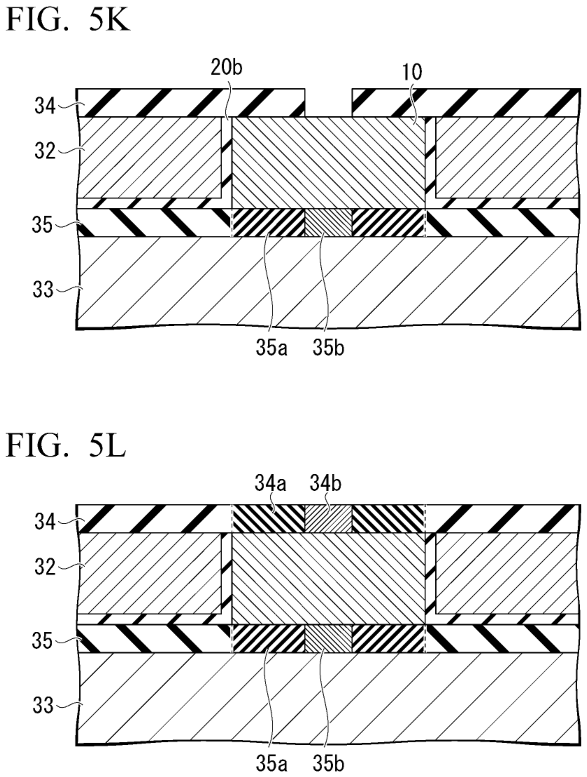

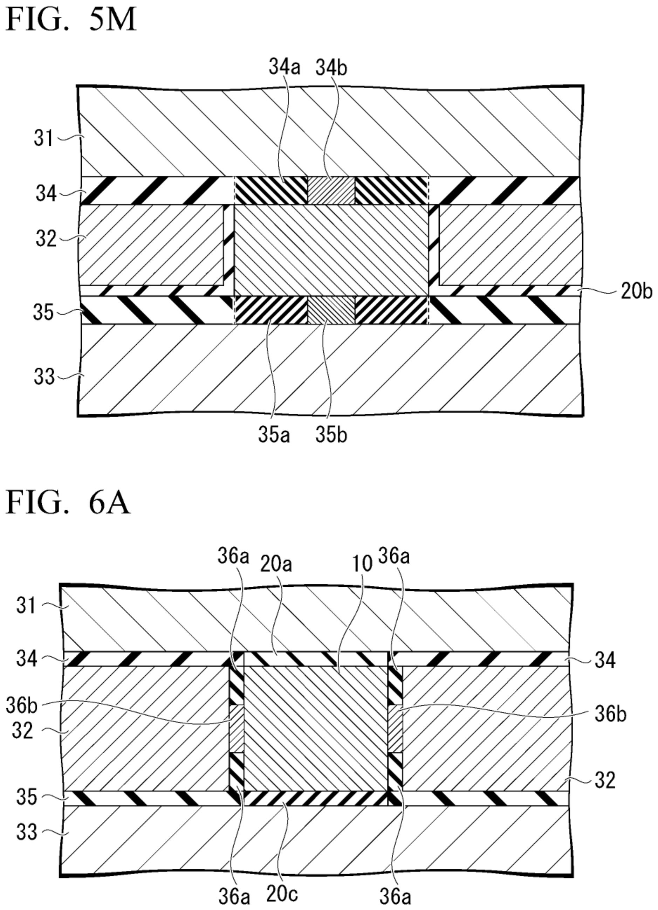

(1) As shown in FIG. 5A, a photoresist 38 is formed in a region on the lower shield 33 in which the low-resistance pinhole layer 35b is to be formed. Next, the high-resistance layer 35 is formed on a portion of the lower shield 33, which is not coated with the photoresist 38, by sputtering or atomic layer deposition (ALD). Here, the high-resistance layer 35 and the high-resistance layer 35a corresponding to the high-resistance region of the resistance adjustment layer are simultaneously formed using the same material.
(2) As shown in FIG. 5B, the photoresist 38 is peeled off to expose the region in which the low-resistance pinhole layer 35b is to be formed.
(3) The low-resistance pinhole layer 35b is formed as shown in FIG. 5C.
(4) As shown in FIG. 5D, a film, which is formed on the high-resistance layer 35 and is equivalent to the low-resistance pinhole layer 35b, is removed by chemical mechanical polishing or the like. The low-resistance pinhole layer 35b and the high-resistance layer (or the insulator layer) 35 and the high-resistance layer 35a corresponding to the high-resistance region of the resistance adjustment layer are planarized.
(5) As shown in FIG. 5E, a ferromagnetic body 10a is formed on the high-resistance layer 35, the high-resistance layer 35a corresponding to the high-resistance region of the resistance adjustment layer, and the low-resistance pinhole layer 35b.
(6) As shown in FIG. 5F, a photoresist 39 is formed on the formed ferromagnetic body 10a. Next, a part of the ferromagnetic body 10a is etched via the photoresist 39 by argon ion milling or the like to form the ferromagnetic body 10.
(7) As shown in FIG. 5G, the non-magnetic layer 20b made of Ru or the like is formed by ALD or the like, and then the side shield 32 is formed on the high-resistance layer (or the insulator layer) 35.
(8) As shown in FIG. 5H, argon ion milling is performed with a direction, which is inclined with respect to a normal to a substrate surface, as an incident direction to remove the side shield 32 and the non-magnetic layer 20b deposited on the side walls of the photoresist 39.
(9) As shown in FIG. 5I, the photoresist 39 is trimmed by dry etching using oxygen gas or the like. The width of the photoresist 39 is reduced until the width of the photoresist 39 reaches a width corresponding to a region in which the low-resistance pinhole layer 34b is to be formed.
(10) As shown in FIG. 5J, the high-resistance layer (or the insulator layer) 34 is formed on the side shields 32 by ALD or the like. The high-resistance layer 34a is formed on an exposed surface of the ferromagnetic body 10 except for the region in which the low-resistance pinhole layer 34b is to be formed.
(11) As shown in FIG. 5K, the photoresist 39 remaining in FIG. 5I is peeled off. Since the photoresist 39 is peeled off, the region in which the low-resistance pinhole layer 34 is to be formed is exposed.
(12) As shown in FIG. 5L, the low-resistance pinhole layer 34b is formed on the ferromagnetic body 10 by the same method as in the processes (3) and (4), and is then planarized by chemical mechanical polishing or the like.
(13) As shown in FIG. 5M, the upper shield 31 is formed on the low-resistance pinhole layer 34b, the high-resistance layer 34a, and the high-resistance layer (or the insulator layer) 34.

Further, a nanocomposite structure in which metal particles are dispersed in an insulator may be used as the resistance adjustment layer. The nanocomposite structure is provided between the ferromagnetic body 10 and the lower shield 33 and the upper shield 31. Even in this case, an increase in output voltage can be obtained as in a case where the low-resistance pinhole layer is provided in the resistance adjustment layer. The nanocomposite structure can be produced, for example, by the following manufacturing method.
(1) A method of simultaneously forming films made of a non-solid-solution insulator and metal on portions adjacent to upper and lower sides of the ferromagnetic body 10 and separating phases.
(2) A method of forming films made of an Al-Cu alloy on portions adjacent to upper and lower sides of the ferromagnetic body 10 and then exposing the films to oxygen or oxygen plasma to preferentially oxidize Al.
(3) A method of forming thin precursor films made of Ag-In-Zn-O on portions adjacent to upper and lower sides of the ferromagnetic body 10 and performing heat treatment to cause a redox reaction between Mn contained in the ferromagnetic body 10 and In₂O₃ contained in a precursor.

The recording head according to the first embodiment may have a structure conforming to the structure of the first type of recording head using the anomalous Hall effect shown in FIG. 1B, for example, as shown in FIG. 9A. In this case, the low-resistance pinhole layers 34b and 35b surrounded by the high-resistance layers 34a and 35a are provided between the upper and lower shields 31 and 33 and the ferromagnetic body 10. The low-resistance pinhole layers 34b and 35b prevent a bias current (first direction) flowing through the ferromagnetic body 10 from being shunted to the upper and lower shields 31 and 33 in a case where the side shields 32 are used as the bias current terminals (I+, I-). As a result, an output voltage measured between the upper and lower shields 31 and 33 is increased as compared with a case where the low-resistance pinhole layers 34b and 35b are not provided.

Alternatively, the recording head according to the first embodiment may have the structure of the second type of recording head using the anomalous Hall effect shown in FIG. 1C, for example, as shown in FIG. 10A. In this case, the low-resistance pinhole layers 34b and 35b surrounded by the high-resistance layers 34a and 35a are provided between the upper and lower shields 31 and 33 and the ferromagnetic body 10. The low-resistance pinhole layers 34b and 35b suppress a phenomenon in which an output voltage caused by the anomalous Hall effect occurring in the ferromagnetic body 10 leaks due to the upper and lower shields 31 and 33 in a case where the upper and lower shields 31 and 33 are used as the bias current terminals (I+, I-). As a result, an output voltage measured between the side shields 32, which corresponds to a voltage generated between the pair of voltage detection terminals V+ and V-, is increased as compared with a case where the low-resistance pinhole layers 34b and 35b are not provided.

### <Second embodiment>

FIG. 6A is a configuration diagram of a recording head using the anomalous Hall effect according to a second embodiment. FIG. 6A is the same as FIG. 2B.

The recording head according to the second embodiment includes a laminate of metal thin films that are formed of soft magnetic bodies and surround a ferromagnetic body 10 as shown in FIG. 2B. Each of the soft magnetic bodies is called an upper shield 31, a lower shield 33, and side shields 32. Details of the structure of the recording head will be described. A high-resistance layer (or an insulator layer) 34 is provided between the upper shield 31 and the side shields 32, and a high-resistance layer (or an insulator layer) 35 is provided between the lower shield 33 and the side shields 32. A non-magnetic layer 20a is provided between the ferromagnetic body 10 and the upper shield 31. A non-magnetic layer 20c is provided between the ferromagnetic body 10 and the lower shield 33. A high-resistance layer 36a corresponding to a high-resistance region and a low-resistance pinhole layer 36b corresponding to a low-resistance region of the resistance adjustment layer are provided between the ferromagnetic body 10 and each of the side shields 32. The side shields 32 are positioned on the left and right sides of the ferromagnetic body 10 and the non-magnetic layers 20b with the ferromagnetic body 10 and the non-magnetic layers 20b interposed therebetween.

The recording head according to the second embodiment includes the low-resistance pinhole layer 36b surrounded by the high-resistance layer 36a between each side shield 32 and the ferromagnetic body 10. A finite element method simulation was performed to evaluate the effect of this structure.

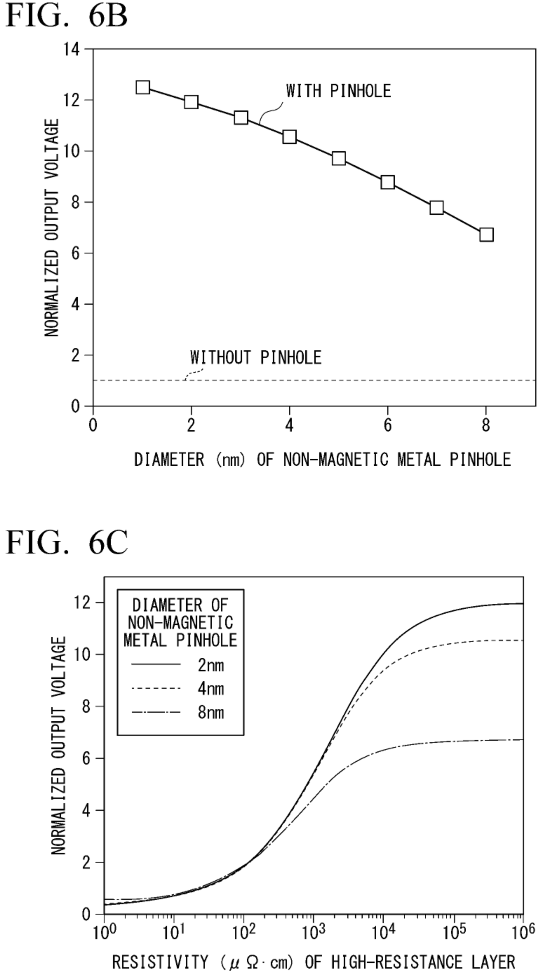

FIG. 6B shows the dependence of an output voltage on the diameter of a pinhole. The output voltage is normalized by a value obtained in a case where a pinhole structure is not provided (the same as FIG. 3B: comparative example). The recording head having a pinhole structure between the ferromagnetic body 10 and each side shield 32 exhibits a high output voltage as compared with the comparative example not having the pinhole structure.

FIG. 6C shows the dependence of an output voltage on the resistivity of the high-resistance layer 36a provided around the pinhole. In a case where the resistance of the high-resistance layer 36a is about 10⁴ µΩ·cm or more, a high output voltage is obtained.

The recording head according to the second embodiment may have the structure of the second type of recording head using the anomalous Hall effect shown in FIG. 1C, for example, as shown in FIG. 10B. In this case, the low-resistance pinhole layer 36b surrounded by the high-resistance layer 36a is provided between each side shield 32 and the ferromagnetic body 10. The low-resistance pinhole layers 36b suppress a phenomenon in which an output voltage caused by the anomalous Hall effect occurring in the ferromagnetic body 10 leaks due to the side shields 32 in a case where the side shields 32 are used as bias current terminals (I+, I-). As a result, an output voltage measured between the upper and lower shields 31 and 33, which corresponds to a voltage generated between the pair of voltage detection terminals V+ and V-, is increased as compared with a case where the low-resistance pinhole layers 36b are not provided.

Further, the recording head according to the second embodiment may have a structure conforming to the structure of the first type of recording head using the anomalous Hall effect shown in FIG. 1B, for example, as shown in FIG. 9B. In this case, the low-resistance pinhole layer 36b surrounded by the high-resistance layer 36a is provided between each side shield 32 and the ferromagnetic body 10. The low-resistance pinhole layers 36b prevent a bias current (first direction) flowing through the ferromagnetic body 10 from being shunted to the side shields 32 in a case where the upper and lower shields 31 and 33 are used as the bias current terminals (I+, I-). As a result, an output voltage measured between the side shields 32 is increased as compared with a case where the low-resistance pinhole layers 36b are not provided.

### <Third embodiment>

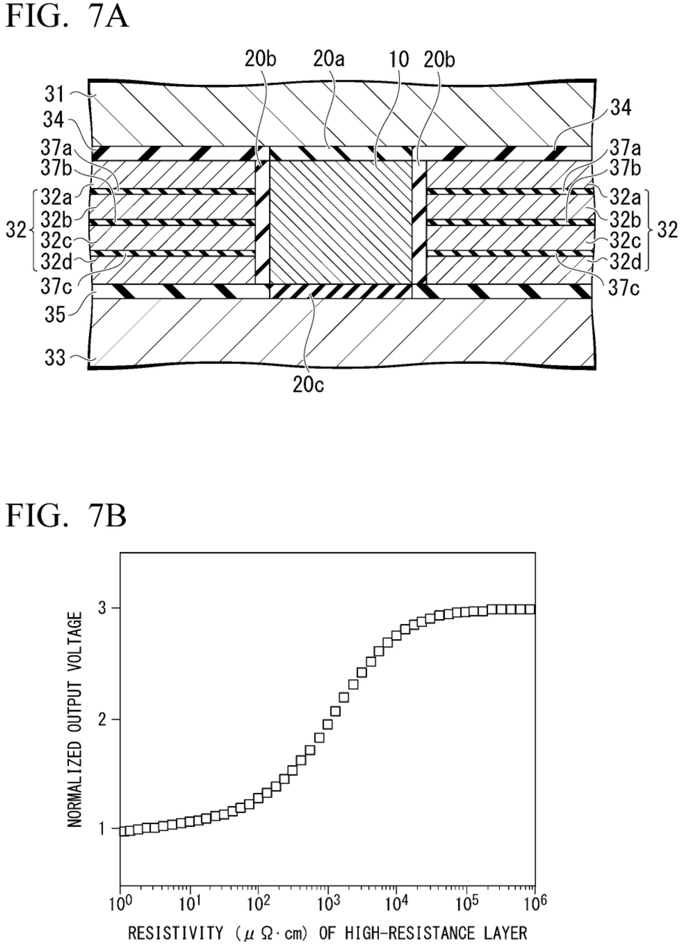

A recording head according to a third embodiment includes a laminate of metal thin films that are formed of soft magnetic bodies and surround a ferromagnetic body 10 as shown in FIGS. 2C and 7A. Each of the soft magnetic bodies is called an upper shield 31, a lower shield 33, and side shields 32. Details of the structure of the recording head will be described. A high-resistance layer (or an insulator layer) 34 is provided between the upper shield 31 and the side shields 32, and a high-resistance layer (or an insulator layer) 35 is provided between the lower shield 33 and the side shields 32. A non-magnetic layer 20a is provided between the ferromagnetic body 10 and the upper shield 31. A non-magnetic layer 20c is provided between the ferromagnetic body 10 and the lower shield 33. A non-magnetic layer 20b is provided between the ferromagnetic body 10 and each of the side shields 32. The side shields 32 are positioned on the left and right sides of the ferromagnetic body 10 and the non-magnetic layers 20b with the ferromagnetic body 10 and the non-magnetic layers 20b interposed therebetween.

The side shields 32 of the third embodiment use a laminated structure of soft magnetic metal layers 32a, 32b, and 32c and high-resistance layers 37a and 37b. The soft magnetic metal layers and the high-resistance layers are alternately laminated. The soft magnetic metal layer corresponds to a soft magnetic layer, and the high-resistance layer corresponds to an intermediate layer.

The thickness of each of the soft magnetic metal layers 32a, 32b, and 32c may be 2 times or more and 10 times or less the thickness of each of the high-resistance layers 37a and 37b. The ratio of the resistivity of each of the high-resistance layers 37a and 37b to the resistivity of each of the soft magnetic metal layers 32a, 32b, and 32c is preferably 100 or more and 10⁶ or less and more preferably 100 or more and 10⁴ or less.

The resistivity of each of the high-resistance layers 37a and 37b may be 10⁴ µΩ·cm or more and 10⁸ µΩ·cm or less. The resistivity of each of the soft magnetic metal layers 32a, 32b, and 32c may be 10² µΩ·cm or more and 10⁴ µΩ·cm or less. Further, the soft magnetic metal layers 32a, 32b, and 32c may contain, for example, NiFe. The high-resistance layers 37a and 37b may contain, for example, an oxide or a nitride selected from the group consisting of SiOₓ, AlOₓ, MgO, MgTiO, MgAl, TaOₓ, HfOₓ, and SiN.

The recording head according to the third embodiment has a laminated structure of the soft magnetic metal layers 32a, 32b, and 32c and the high-resistance layers 37a and 37b in each of the side shields 32. A finite element method simulation was performed to evaluate the effect of this structure.

As shown in FIG. 7A, the side shield 32 has a structure in which the soft magnetic metal layer (2.5 nm), the high-resistance layer (1.0 nm), the soft magnetic metal layer (2.5 nm), the high-resistance layer (1.0 nm), the soft magnetic metal layer (2.5 nm), the high-resistance layer (1.0 nm), and the soft magnetic metal layer (2.5 nm) are laminated. Here, the number of high-resistance layers is 3, but is an example. The number of high-resistance layers is not limited to 3. The soft magnetic metal layers 32a, 32b, and 32c are made of, for example, NiFe, and it is assumed that the soft magnetic metal layers 32a, 32b, and 32c have a resistivity of 20 µΩ·cm. FIG. 7B shows the dependence of an output voltage of the recording head including such side shields 32 on the resistivity of the high-resistance layers 37a and 37b. In a case where the resistivity of the high-resistance layers 37a and 37b is about 10⁴ µΩ·cm or more, the output voltage is saturated.

This means that the high-resistance layers 37a and 37b do not have to be insulators as long as the high-resistance layers 37a and 37b have a resistivity of about 10⁴ µΩ·cm or more. The thickness of each of the high-resistance layers 37a and 37b is set to 1.0 nm in the present example, but a resistivity of 10⁴ µΩ·cm corresponds to the product (RA) of the resistance of 0.1 Ω·µm² and the area. In a case where a magnesium oxide of about 1 nm is used for the high-resistance layers 37a and 37b, an RA value of about 1 Ω·µm² or less is obtained. It is known that ferromagnetic exchange coupling acts between two ferromagnetic layers with such a magnesium oxide having a low RA value interposed therebetween. Such ferromagnetic exchange coupling is advantageous for the characteristics of the side shields 32 since the ferromagnetic exchange coupling promotes magnetic stability as the side shields 32.

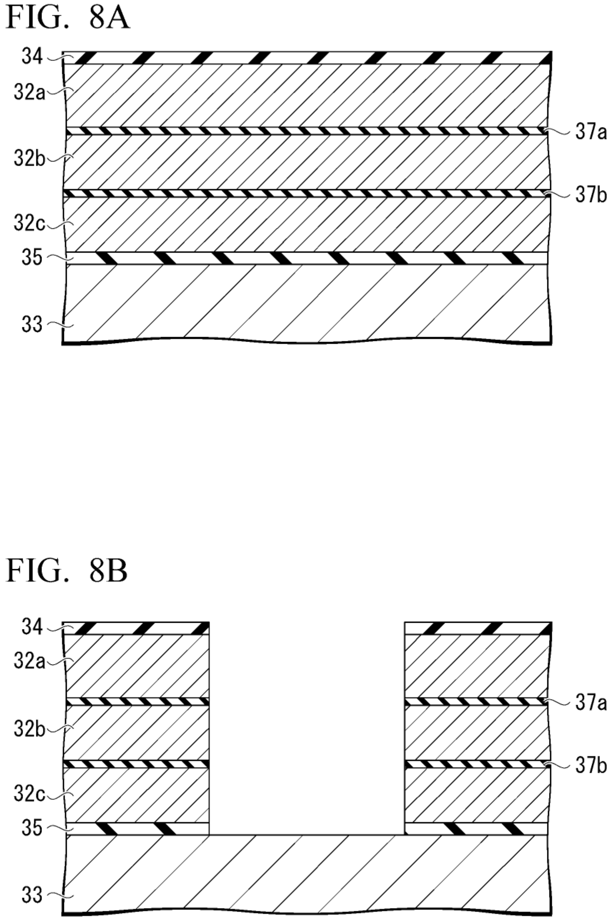

FIGS. 8A to 8E show processes for producing the recording head using the side shields 32 having the laminated structure of the soft magnetic metal layers 32a, 32b, and 32c and the high-resistance layers 37a and 37b.

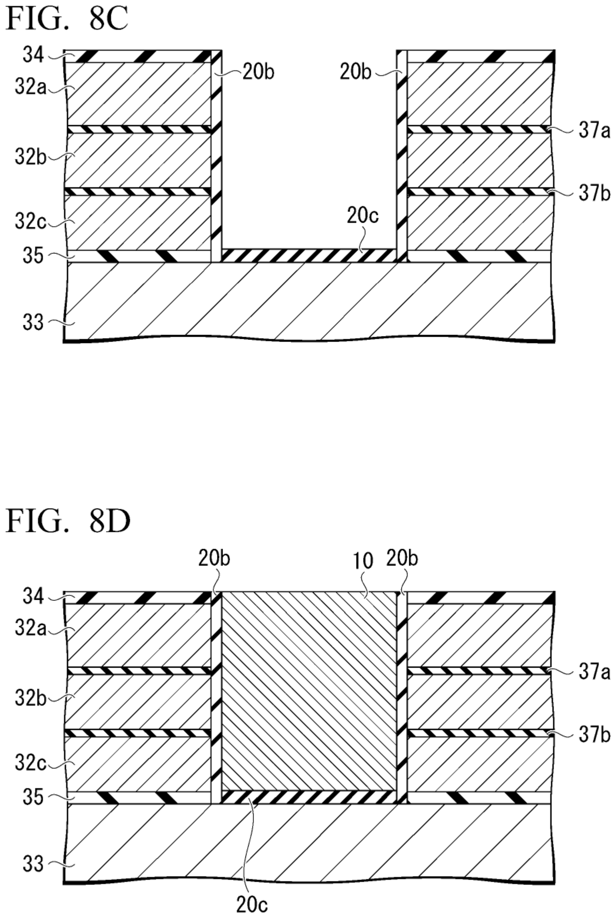

(1) As shown in FIG. 8A, the insulator layer 35 is formed on the lower shield 33. Next, the soft magnetic metal layers 32a, 32b, and 32c and the high-resistance layers 37a and 37b are alternately formed on the insulator layer 35, and the insulator layer 34 is formed thereon.
(2) As shown in FIG. 8B, a trench penetrating the side shield 32 is formed by ion milling or dry etching.
(3) As shown in FIG. 8C, the non-magnetic layer 20c (Ru or the like) is deposited on a bottom portion of the trench and the non-magnetic layers 20b (Ru or the like) are deposited on side walls of the trench, using atomic layer deposition (ALD).
(4) As shown in FIG. 8D, a layer of the ferromagnetic body 10 is formed in the trench and the surface of the layer is planarized.
(5) As shown in FIG. 8E, the non-magnetic layer 20a is formed on the layer of the ferromagnetic body 10 and the soft magnetic metal layer 32a, and then the upper shield 31 is formed.

The recording head according to the third embodiment may have the structure of the second type of recording head using the anomalous Hall effect shown in FIG. 1C, for example, as shown in FIG. 10C. In this case, the recording head has the laminated structure of the soft magnetic metal layers 32a, 32b, and 32c and the high-resistance layers 37a and 37b in each of the side shields 32. The side shields 32 having the laminated structure suppress a phenomenon in which an output voltage caused by the anomalous Hall effect occurring in the ferromagnetic body 10 leaks due to the side shields 32 in a case where the side shields 32 are used as the bias current terminals (I+, I-). As a result, an output voltage measured between the upper and lower shields 31 and 33, which corresponds to a voltage generated between the pair of voltage detection terminals V+ and V-, is increased as compared with a case where this laminated structure is not provided.

Alternatively, the recording head according to the third embodiment may have a structure conforming to the structure of the first type of recording head using the anomalous Hall effect shown in FIG. 1B, for example, as shown in FIG. 9C. In this case, the recording head has the laminated structure of the soft magnetic metal layers 32a, 32b, and 32c and the high-resistance layers 37a and 37b in each of the side shields 32. The side shields 32 having the laminated structure prevent a bias current (first direction) flowing through the ferromagnetic body 10 from being shunted to the side shields 32 in a case where the upper and lower shields 31 and 33 are used as the bias current terminals (I+, I-). As a result, an output voltage measured between the side shields 32 is increased as compared with a case where the laminated structure is not provided.

Although examples of each of a case where the resistance adjustment layer is provided between each of the upper and lower shields and the ferromagnetic body, a case where the resistance adjustment layer is provided between each of the side shields and the ferromagnetic body, and a case where the laminated structure of the soft magnetic bodies and the high resistance is provided in each of the side shields have been described in the above-described embodiments, these structures may be combined.

### INDUSTRIAL APPLICABILITY

Since the shunting of a bias current to the voltage detection terminal or the leakage of an anomalous Hall voltage to the bias current terminal is suppressed in the recording head using the anomalous Hall effect according to the present disclosure, an output voltage is not likely to decrease. Therefore, the recording head according to the present disclosure has a large output and can be suitably used for a magnetic storage device.

### REFERENCE SIGNS LIST

10 Ferromagnetic body
20a, 20b, 20c Non-magnetic layer
31 Upper shield
32 Side shield
32a, 32b, 32c, 32d Soft magnetic metal layer
33 Lower shield
34, 35 Insulator layer
34a, 35a High-resistance layer (high-resistance region of resistance adjustment layer)
34b, 35b Low-resistance pinhole layer (low-resistance region of resistance adjustment layer)
37a, 37b Insulator layer (high-resistance layer)
38, 39 Photoresist
I+, I- Bias current terminal
V+, V- Voltage detection terminal

## Claims

1. A recording head using an anomalous Hall effect, comprising:
a ferromagnetic body configured to exhibit the anomalous Hall effect;
a first current terminal and a second current terminal configured to supply a current to the ferromagnetic body;
a first voltage terminal and a second voltage terminal configured to detect a voltage generated in the ferromagnetic body; and
a resistance adjustment layer provided between each of the first and second current terminals and the ferromagnetic body or between each of the first and second voltage terminals and the ferromagnetic body,
wherein, in a case where a current direction of a current flowing between the first and second current terminals is defined as a first direction and a voltage direction of a voltage generated between the first and second voltage terminals is defined as a second direction, a magnetic field applied in a third direction orthogonal to an air bearing surface is detectable using the anomalous Hall effect,
the resistance adjustment layer includes a high-resistance region and a low-resistance region, and
the low-resistance region electrically connects each of the first and second current terminals and the ferromagnetic body or electrically connects each of the first and second voltage terminals and the ferromagnetic body.

2. The recording head using the anomalous Hall effect according to Claim 1,
wherein the low-resistance region is present at a center of the resistance adjustment layer.

3. The recording head using the anomalous Hall effect according to Claim 1,
wherein the ferromagnetic body contains at least two elements selected from the group consisting of cobalt, nickel, iron, holmium, platinum, osmium, bismuth, boron, dysprosium, gadolinium, and terbium.

4. The recording head using the anomalous Hall effect according to Claim 1,
wherein a ratio of a resistivity of the high-resistance region to a resistivity of the low-resistance region is 100 or more.

5. The recording head using the anomalous Hall effect according to Claim 4,
wherein the resistivity of the high-resistance region is 10⁴ µΩ·cm or more and 10⁸ µΩ·cm or less.

6. The recording head using the anomalous Hall effect according to Claim 5,
wherein the resistivity of the low-resistance region is 10² µΩ·cm or more and 10⁴ µΩ·cm or less.

7. The recording head using the anomalous Hall effect according to Claim 1,
wherein the high-resistance region contains an oxide or a nitride selected from the group consisting of SiOₓ, AlOₓ, MgO, MgTiO, MgAl, TaOₓ, HfOₓ, and SiN.

8. The recording head using the anomalous Hall effect according to Claim 1,
wherein the low-resistance region contains a metal selected from the group consisting of Ru, Ag, Au, Cu, and Ta or an alloy of these metal elements.

9. The recording head using the anomalous Hall effect according to Claim 1,
wherein a material of the ferromagnetic body is an alloy exhibiting an anomalous Hall resistivity of 1 µΩ·cm or more.

10. The recording head using the anomalous Hall effect according to Claim 9,
wherein the material of the ferromagnetic body includes an alloy selected from the group consisting of Co₂MnAl, Co₂MnGa, and FeSn.

11. The recording head using the anomalous Hall effect according to Claim 1,
wherein the first current terminal, the second current terminal, the first voltage terminal, and the second voltage terminal contain a soft-magnetic ferromagnetic material.

12. The recording head using the anomalous Hall effect according to Claim 11,
wherein the first current terminal, the second current terminal, the first voltage terminal, and the second voltage terminal contain NiFe.

13. The recording head using the anomalous Hall effect according to Claim 1,
wherein the third direction is orthogonal to the first direction and the second direction.

14. A recording head using an anomalous Hall effect, comprising:
a ferromagnetic body configured to exhibit the anomalous Hall effect;
a first current terminal and a second current terminal configured to supply a current to the ferromagnetic body; and
a first voltage terminal and a second voltage terminal configured to detect a voltage generated in the ferromagnetic body,
wherein, in a case where a flow direction of a current flowing between the first and second current terminals is defined as a first direction and a generation direction of a voltage generated between the first and second voltage terminals is defined as a second direction, a magnetic field applied in a third direction orthogonal to an air bearing surface is detectable using the anomalous Hall effect,
each of the first current terminal and the second current terminal have a multilayer structure, and
soft magnetic layers and intermediate layers extending along the second direction are alternately laminated in the multilayer structure, and the intermediate layer has a higher resistance than the soft magnetic layer.

15. The recording head using the anomalous Hall effect according to Claim 14,
wherein a ratio of a resistivity of the intermediate layer to a resistivity of the soft magnetic layer is 100 or more.

16. The recording head using the anomalous Hall effect according to Claim 14,
wherein the soft magnetic layer contains a soft-magnetic ferromagnetic material.

17. The recording head using the anomalous Hall effect according to Claim 16,
wherein the soft magnetic layer contains NiFe.

18. The recording head using the anomalous Hall effect according to Claim 14,
wherein the intermediate layer contains an oxide or a nitride selected from the group consisting of SiOₓ, AlOₓ, MgO, MgTiO, MgAlO, TaOₓ, HfOₓ, and SiN.

19. The recording head using the anomalous Hall effect according to Claim 14,
wherein a thickness of the soft magnetic layer is 2 times or more a thickness of the intermediate layer.

20. The recording head using the anomalous Hall effect according to Claim 14,
wherein the first and second voltage terminals contain a soft-magnetic ferromagnetic material.

21. The recording head using the anomalous Hall effect according to Claim 20,
wherein the first and second voltage terminals contain NiFe.

22. The recording head using the anomalous Hall effect according to Claim 14,
wherein the third direction is orthogonal to the first direction and the second direction.

23. A magnetic disk device comprising:
a magnetic head;
a slider disposed to face a recording medium to be rotationally driven; and
a positioning device configured to support the slider and to position the slider with respect to the recording medium,
wherein the magnetic head has a medium-facing surface facing the recording medium, and
the magnetic head includes the recording head using the anomalous Hall effect according to any one of Claims 1 to 22 in a vicinity of the medium-facing surface.

24. A magnetic storage device comprising:
a magnetic recording medium having a magnetic storage pattern disposed in stripes in an in-plane direction and configured to perform magnetic storage by perpendicular magnetization; and
a recording head facing the magnetic recording medium and configured to read the magnetic storage pattern,
wherein the recording head is the recording head using the anomalous Hall effect according to any one of Claims 1 to 22.
